# EUROPEAN PATENT APPLICATION

(11) **EP 3 439 102 A1**
(43) Date of publication of application: **06.02.2019**
(21) Application number: 18185880.4
(22) Date of filing: 26.07.2018
(51) Int. Cl.: H01Q 1/22, H01Q 5/364, H01Q 9/04, H01Q 9/42

(54) **ONE-PIECE DUAL-BAND ANTENNA AND GROUND PLANE**

(30) Priority: 02.08.2017 US 201762540374 P; 01.05.2018 US 201815968487
(71) Applicant: PC-Tel, Inc., Bloomingdale, IL 60108 (US)
(72) Inventor: MCGOUGH, Erin, Bloomingdate, Illinois 60108 (US)
(74) Representative: Haseltine Lake LLP

(57) **Abstract**

A cost effective, highly tunable, compact, dual-band, omnidirectional antenna element is provided that includes its own radiating and ground plane sections that can be stamped and formed from a single piece of sheet metal. The antenna element can be tuned to operate in different driving point environments over a plurality of frequency bands and can be terminated to a feed connection point in multiple ways. The antenna element can have a lightweight and compact form factor, thereby allowing the antenna element to be comfortably placed and supported within access point products. Some embodiments can achieve an efficient dual-band response and omnidirectional radiation patterns suited for deployment in ceiling-mounted enterprise Wi-Fi access points.

## Description

### CROSS-REFERENCE TO RELATED APPLICATIONS

This application claims priority to U.S. Provisional Patent Application No. 62/540,374 filed August 2, 2017 and titled "HIGHLY TUNABLE ONE PIECE DUAL BAND ANTENNA AND GROUND PLANE." U.S. Provisional Patent Application No. 62/540,374 is hereby incorporated herein by reference.

### FIELD

The present invention relates generally to radio frequency (RF) communications hardware. More particularly, the present invention relates to a one-piece dual-band antenna and ground plane.

### BACKGROUND

Within enterprise access points, embedded antennas are often fastened to a sizable ground plane. However necessary this approach is at times (e.g. to preserve radio sensitivity), a cheaper solution exists in which the antennas comprise their own radiating and ground plane portions. Some antennas have been developed in this vein, including the antenna disclosed in U.S. Publication No. 2016/0149303. However, such antennas are unsuitable because they possess directional radiation characteristics.

In view of the above, there is a continuing, ongoing need for improved antennas.

### BRIEF DESCRIPTION OF THE DRAWINGS

FIG. 1 is a perspective view of a one-piece dual-band antenna and ground plane in accordance with disclosed embodiments;
FIG. 2 is a graph of a simulated voltage standing wave ratio of the one-piece dual-band antenna and ground plane of FIG. 1;
FIG. 3 is a graph of an azimuth plane radiation pattern of the one-piece dual-band antenna and ground plane of FIG. 1 operating at 2.45 GHz;
FIG. 4 is a graph of an elevation plane radiation pattern of the one-piece dual-band antenna and ground plane of FIG. 1 operating at 2.45 GHz;
FIG. 5 is a graph of an azimuth plane radiation pattern of the one-piece dual-band antenna and ground plane of FIG. 1 operating at 5.5 GHz;
FIG. 6 is a graph of an elevation plane radiation pattern of the one-piece dual-band antenna and ground plane of FIG. 1 operating at 5.5 GHz.
FIG. 7 is a perspective view of a one-piece dual-band antenna and ground plane in accordance with disclosed embodiments;
FIG. 8 is a graph of a simulated voltage standing wave ratio of the one-piece dual-band antenna and ground plane of FIG. 7;
FIG. 9A is a perspective view of a one-piece dual-band antenna and ground plane in accordance with disclosed embodiments;
FIG. 9B is a perspective view of a one-piece dual-band antenna and ground plane in accordance with disclosed embodiments;
FIG. 9C is a perspective view of a one-piece dual-band antenna and ground plane in accordance with disclosed embodiments;
FIG. 10 is a graph illustrating a surface current distribution of a one-piece dual-band antenna and ground plane in accordance with disclosed embodiments operating at 2.45 GHz; and
FIG. 11 is a graph illustrating a surface current distribution of a one-piece dual-band antenna and ground plane in accordance with disclosed embodiments operating at 5.5 GHz.

### DETAILED DESCRIPTION

While this invention is susceptible of an embodiment in many different forms, there are shown in the drawings and will be described herein in detail specific embodiments thereof with the understanding that the present disclosure is to be considered as an exemplification of the principles of the invention. It is not intended to limit the invention to the specific illustrated embodiments.

Embodiments disclosed herein can include a one-piece dual-band antenna and an integrated ground plane, which is referred to herein as "the element." Advantageously, the element disclosed herein can be cost effective, compact, dual-band, efficient, omnidirectional, highly tunable to operate over a plurality of frequency bands, and include its own ground plane that is simply terminated to a feed connection and easily supported within an access point product. For example, a large ground plane as known in the art can be replaced by a small ground plane that is part of the antenna itself, thereby reducing production costs and part count. In some embodiments, the element disclosed herein can also be heat-staked to a radome, thereby eliminating mounting hardware, such as plastic supports, screws, rivets, and the like, and further reducing production costs and part count.

In accordance with disclosed embodiments, the element can be stamped and formed as a single monolithic structure from a single piece of metal, e.g. sheet metal. Furthermore, the element may employ a variety of feed techniques. For example, in some embodiments, the element can be fed from a top side of the element's ground plane, thereby minimizing the overall height of the element and simplifying attachment of a coaxial cable. Alternatively, in some embodiments, the element can be fed from a bottom side of the element's ground plane, thereby partially shielding the coaxial cable from a radiating section of the element to minimize common mode coupling. In some embodiments, the element can achieve vertically-polarized omnidirectional radiation patterns suited for ceiling-mount applications. In still other embodiments, the element disclosed herein can be integrated into an access point with or without a separate large ground plane.

In some embodiments, a first portion of the element's radiating section can operate in a first frequency band, such as, for example, a low frequency band, including a 2.4 GHz band (2.412-2.483 GHz), and a second portion of the element's radiating section can operate in a second frequency band, such as, for example, a high frequency band, including a 5 GHz band (5.15 - 5.875 GHz). Although the element disclosed herein is described in connection with these particular frequency bands, it is to be understood that the element is not so limited and could be tuned to other frequency bands as would be known and desired by one of ordinary skill in the art to achieve high efficiency in different driving point environments spanning various wireless technologies.

In some embodiments, the first portion of the radiating section can be a quarter-wavelength inverted-F antenna at a low-band frequency design frequency and a half-wavelength long at a high-band design frequency. Furthermore, in some embodiments, the second portion of the radiating section can be a folded quarter-wavelength monopole antenna or other quarter-wavelength resonant structure at the high-band design frequency and appear as an electrically short shunt stub to low frequency current at the low-band design frequency.

In some embodiments, the first portion of the radiating section can achieve a low-band impedance bandwidth of approximately 6% at a 2:1 voltage standing wave ratio and fairly omnidirectional radiation patterns in the azimuth plane. Furthermore, in some embodiments, the low-band impedance bandwidth can be increased by elevating the first portion of the radiating section off the element's ground plane. Further still, in some embodiments, the first portion of the radiating section can have a relatively high input impedance relative to 50 Ohms at the high-band design frequency. However, when the first portion of the radiating section is at or near a multiple of a half-wavelength in length, the first portion of the radiating section can have a relatively high input impedance at the high-band design frequency. Accordingly, some embodiments disclosed herein can take advantage of a times-two frequency ratio between the high-band design frequency and the low-band design frequency.

In some embodiments, a shorting leg coupling the element's radiating section to the element's ground plane can be between an eighth-wavelength and a quarter-wavelength in length as measured with respect to the high-band design frequency. Furthermore, in some embodiments, a susceptance of the shorting leg and a shunt capacitance of the second portion of the radiating section to ground can control the quality and bandwidth of a high-band impedance match.

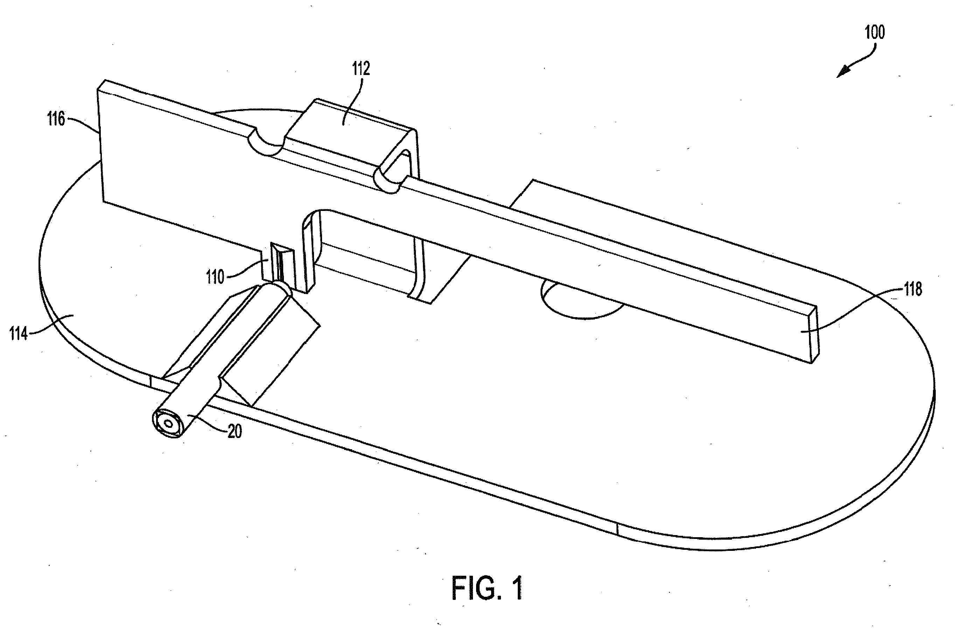

FIG. 1 is a perspective view of an element 100 in accordance with disclosed embodiments. The element 100 can include a feed connection point 110, a shorting leg 112 electrically coupled to the feed connection point 110, a ground plane 114 electrically coupled to the shorting leg 112, a high-band radiating section 116 electrically coupled to the shorting leg 112 and the feed connection point 110, and a low-band radiating section 118 electrically coupled to the shorting leg 112 and the feed connection point 110. The feed connection point 110, the shorting leg 112, the ground plane 114, the high-band radiating section 116, and the low-band radiating section 118 can exist as a single monolithic structure, and in some embodiments, the single monolithic structure can stamped and formed from a single piece of metal.

As seen in FIG. 1, the high-band radiating section 116 and the low-band radiating section 118 can be elevated off the ground plane 114 and located on opposing sides of the shorting leg 112. Respective heights of the high-band radiating section 116 and the low-band radiating section 118 off the ground plane 114 can be adjusted to tune an impedance match at specific operating frequencies. For example, a first height of the high-band radiating section 116 off the ground plane 114 can be varied to tune an input impedance of the element 100 over a high frequency band, and a second height of the low-band radiating section 118 off the ground plane 114 can be varied to tune the input impedance of the element 100 over a low frequency band. In some embodiments, the low-band radiating section 118 can have a first length that is one half of a wavelength at a high-band design frequency as measured from a center of the shorting leg 112 to an end of the low-band radiating section 118, the high-band radiating section 116 can have a second length that is one quarter of the wavelength at the high-band design frequency as measured from the center of the shorting leg 112 to an end of the high-band radiating section 116, and the shorting leg 112 can have a third length that is one quarter of the wavelength at the high-band design frequency. In some embodiments, each of the high-band radiating section 116 and the low-band radiating section 118 can include a respective planar section perpendicular to the ground plane 114.

As seen in FIG. 1, the feed connection point 110 can be isolated from the ground plane 114 to provide a path for current flow from the feed connection point 110 through either (1) the high-band radiating section 116 and the shorting leg 112 or (2) the low-band radiating section 118 and the shorting leg 112. For example, in some embodiments, when a high frequency signal is fed to the feed connection point 110, the low-band radiating section 118 can have a relatively high input impedance that results in the current flow through the high-band radiating section 116 and the shorting leg 112. However, when a low frequency signal is fed to the feed connection point 110, the high-band radiating section 116 can have little radiation length and appear as an electrically short shunt stub, thereby enabling the current flow through the low-band radiating section 118 and the shorting leg 112. In this manner, the element 100 can create a distributed decoupling circuit that forces the low frequency current to the low-band radiating section 118 and high frequency current to the high-band radiating section 116.

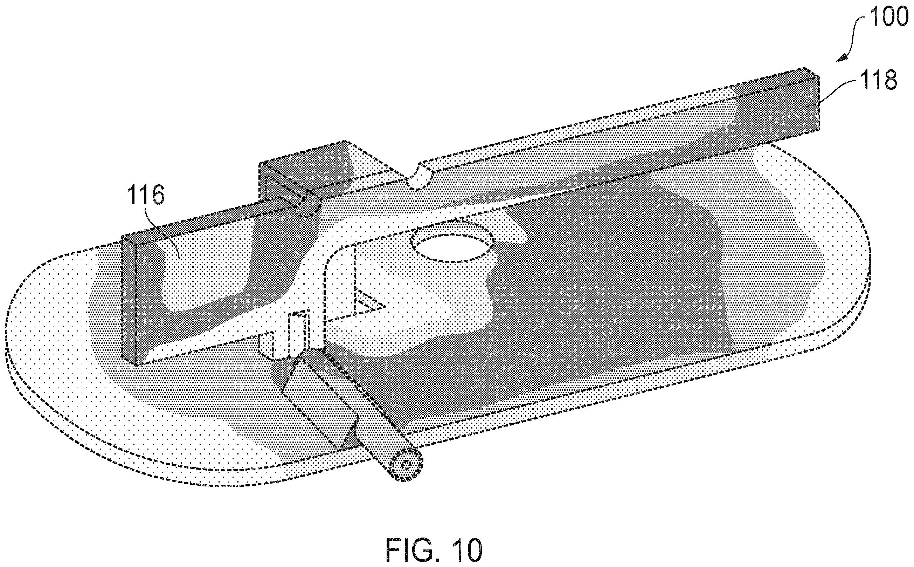

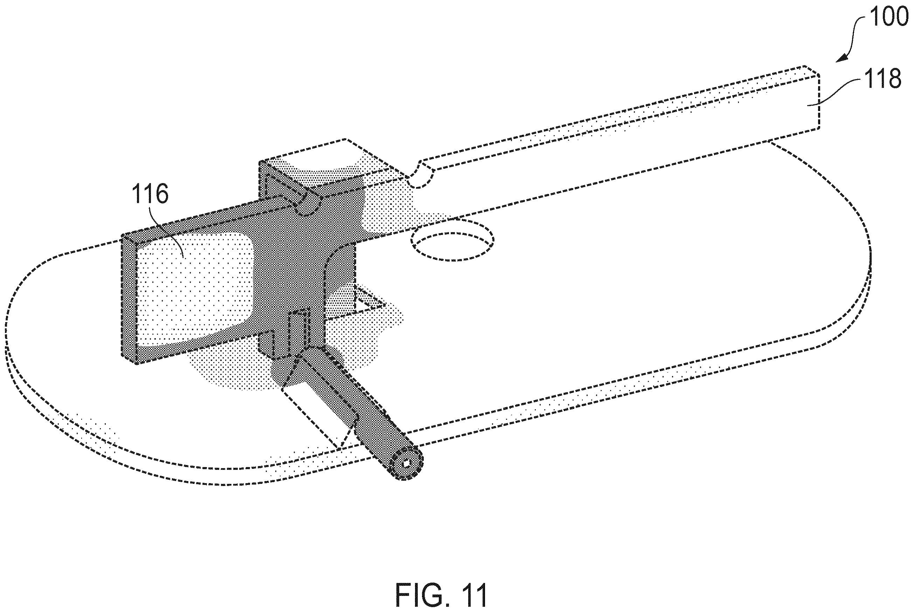

For example, FIG. 10 is a graph illustrating a surface current distribution of the element 100 of FIG. 1 at 2.45 GHz, and FIG. 11 is a graph illustrating the surface current distribution of the element 100 operating at 5.5 GHz. As seen, low frequency current can flow predominantly through the low-band radiating section 118 and the shorting leg 112 whereas high frequency current can flow predominantly the high-band radiating section 116 and near a termination of the shorting leg 112 to the ground plane 114. However, in some embodiments, little of the high frequency current flows through the shorting leg 112 near its connection to the high-band radiating section 116 and the low-band radiating section 118 because the shorting leg 112 has a relatively high input impedance at the high-band design frequency.

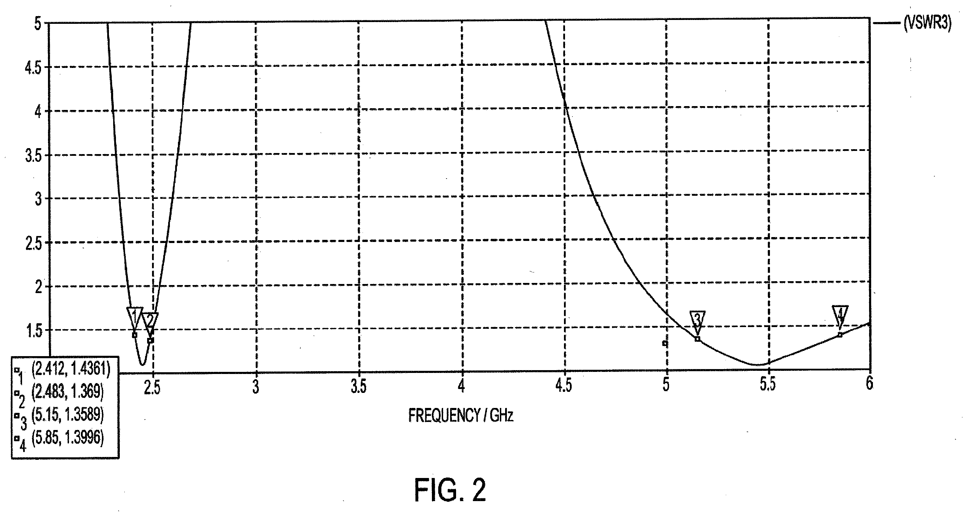

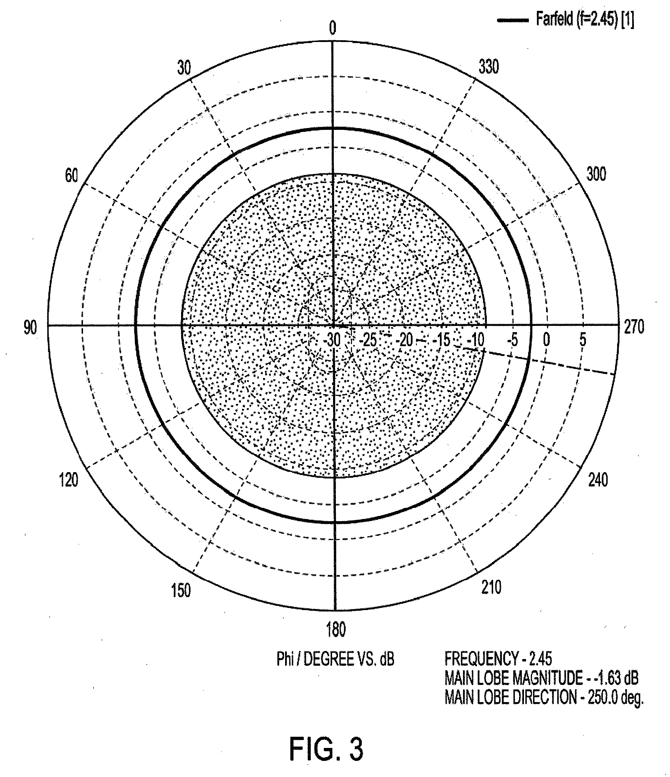

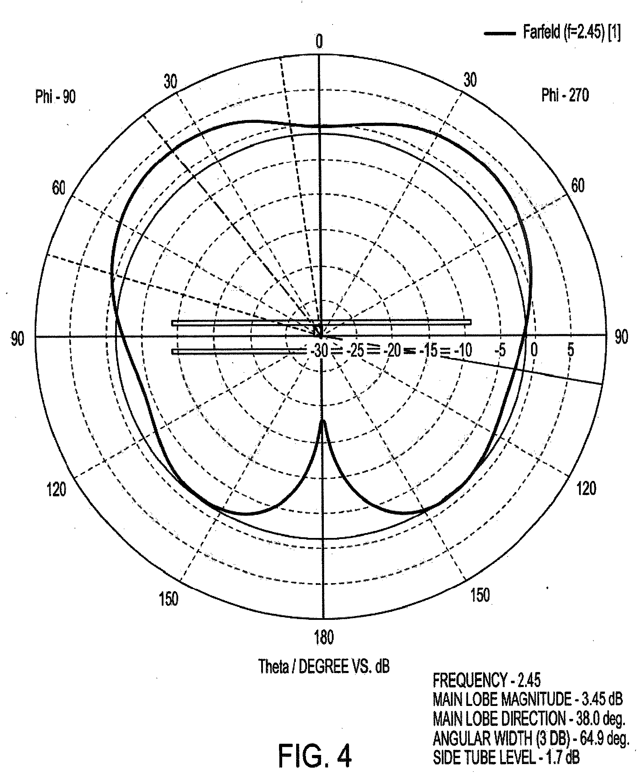

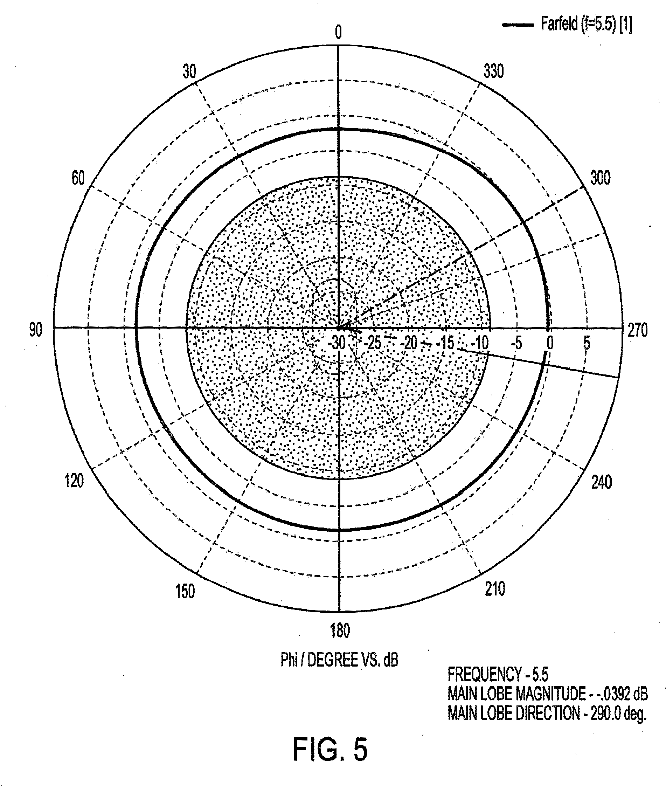

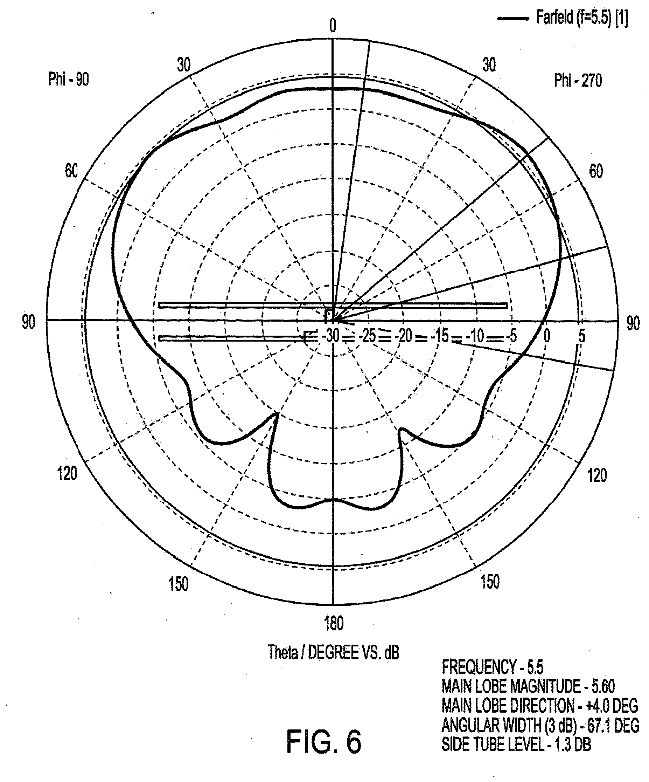

In some embodiments, the element 100 can achieve fairly omnidirectional radiation patterns in both high and low frequency bands and can achieve a high-band impedance bandwidth in excess of 25% that is sufficient to cover the UNII-1, UNII-2, UNII-3, and UNII-4 frequency bands. In this regard, FIG. 2 is a graph of a simulated voltage standing wave ratio of the element 100 of FIG. 1, FIG. 3 is a graph of an azimuth plane radiation pattern of the element 100 operating at 2.45 GHz, FIG. 4 is a graph of an elevation plane radiation pattern of the element 100 operating at 2.45 GHz, FIG. 5 is a graph of an azimuth plane radiation pattern of the element 100 operating at 5.5 GHz, and FIG. 6 is a graph of an elevation plane radiation pattern of the element 100 operating at 5.5 GHz. Such radiation patterns are ideal for an antenna deployed in a ceiling-mounted access point.

As disclosed herein, the element 100 can employ a variety of feed techniques. In this regard, FIG. 1 shows that the element 100 is fed from a top side of the ground plane 114. As seen FIG. 1, a shield of the coaxial cable 20 can be coupled to a top side of the ground plane 114, and a center conductor of the coaxial cable 20 can be coupled to the feed connection point 110, which can be isolated from the ground plane 114 by elevating the feed connection point 110 off the ground plane 112.

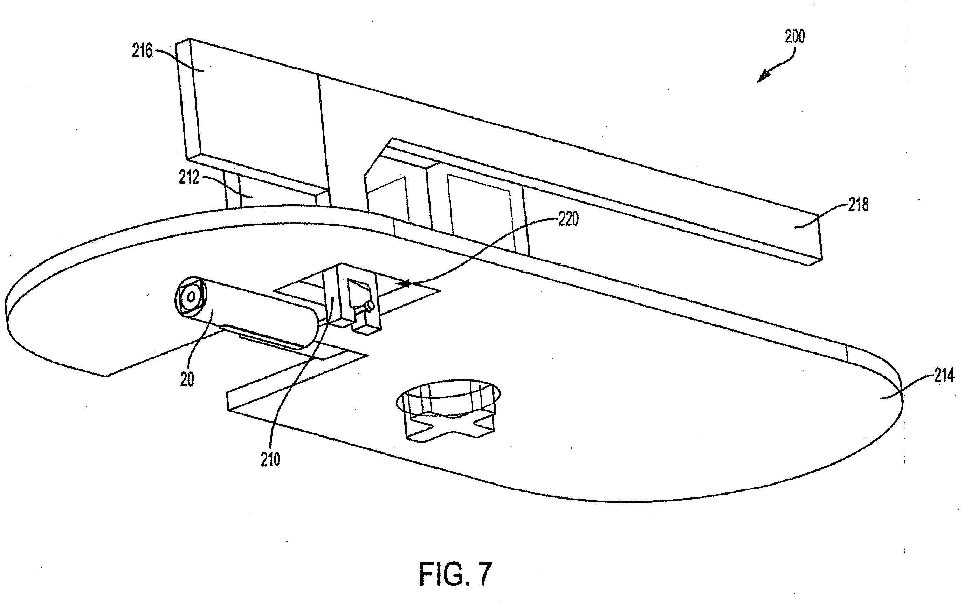

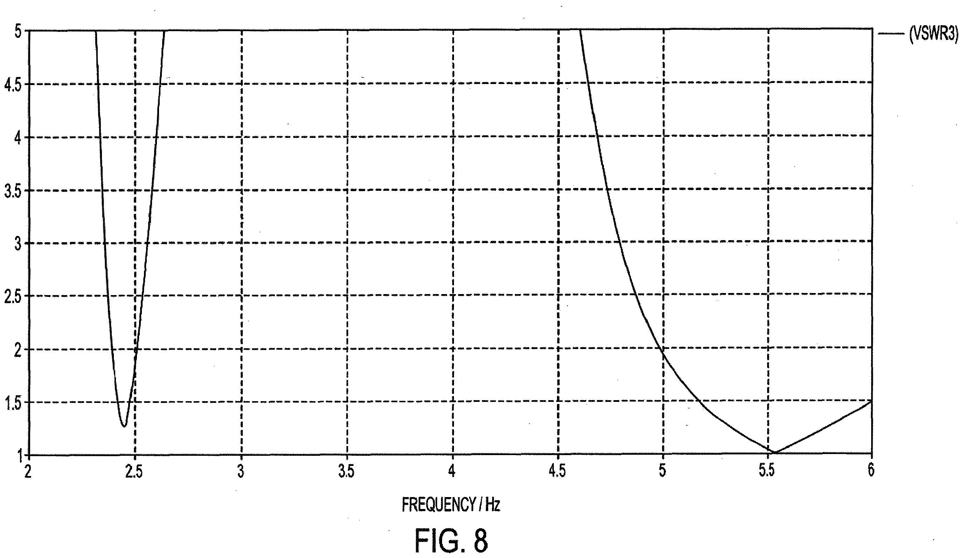

Conversely, FIG. 7 illustrates an element 200 that is fed from a bottom side of a ground plane. The element 200 is similar to the element 100 of FIG. 1 and can exist as a single monolithic structure that forms a feed connection point 210, a shorting leg 212 electrically coupled to the feed connection point 210, a ground plane 214 electrically coupled to the shorting leg 212, a high-band radiating section 216 electrically coupled to the shorting leg 212 and the feed connection point 210, and a low-band radiating section 218 electrically coupled to the shorting circuit leg 212 and the feed connection point 210. However, as seen in FIG. 7, the coaxial cable 20 can feed the element 200 from under the ground plane 214 such that the shield of the coaxial cable 20 can be soldered directly to the bottom side of the ground plane 214, and the center conductor of the coaxial cable 20 can be soldered directly to the feed connection point 210. As seen, the feed connection point 210 can be isolated from the ground plane 214 by routing the feed connection point 212 through a cutout portion 220 of the ground plane 214 so that a connection to the center conductor of the ground plane occurs below the ground plane 214. Advantageously, coupling the coaxial cable 20 to the bottom side of the ground plane 214 can partially shield the coaxial cable 20 from the high-band radiating section 216 and the low-band radiating section 218 to reduce common mode coupling therefrom. In this regard, FIG. 8 is a graph of a simulated voltage standing wave ratio of the element 200 of FIG. 7.

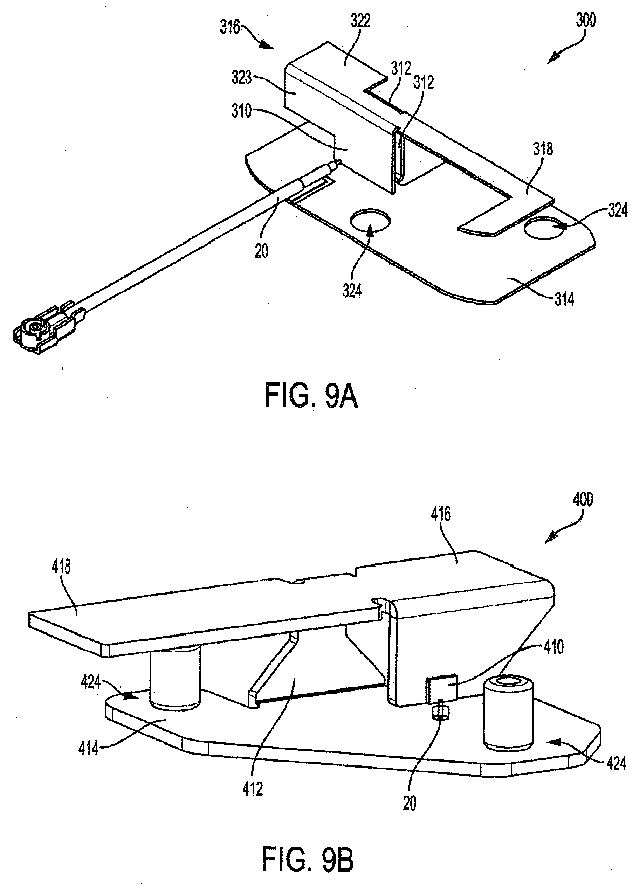

FIG. 9A illustrates another element 300 that is fed from the top side of a ground plane, but includes additional sections that increase mechanical stability and reduce fabrication complexity. The element 300 is similar to the element 100 of FIG. 1 and can exist as a single monolithic structure that forms a feed connection point 310, a shorting leg 312 electrically coupled to the feed connection point 310, a ground plane 314 electrically coupled to the shorting leg 312, a high-band radiating section 316 electrically coupled to the shorting leg 312 and the feed connection point 310, and a low-band radiating section 318 electrically coupled to the shorting leg 312 and the feed connection point 310. However, as seen in FIG. 9A, the high-band radiating section 316 can include a first planar section 322 parallel to the ground plane 314 and a second planar section 323 perpendicular to the ground plane 314, and the low-band radiating section 318 can include a third, bent planar section parallel to the ground plane 314. The orientation of the first and second planar sections 322 and 323 of the high-band high-band radiating section 316 and the third, bent planar section of the low-band radiating section 318 can enhance the mechanical stability of the element 300 and simplify its fabrication. Additionally, the ground plane 314 can include mounting points 324 for coupling the element 300 to an external structure (e.g. a larger ground plane, a radome, a mounting bracket, etc.) via any mounting technique as would be understood by one of ordinary skill in the art (heat staking, plastic supports, screws, rivets, etc.).

FIG. 9B illustrates another element 400 that is fed from the top side of a ground plane and that includes additional sections that increase the mechanical stability of the element 400. The element 400 is similar to the elements 100, 300 of FIG. 1 and FIG. 9A, respectively, and can exist as a single monolithic structure that forms a feed connection point 410, a shorting leg 412 electrically coupled to the feed connection point 410, a ground plane 414 electrically coupled to the shorting leg 412, a high-band radiating section 416 electrically coupled to the shorting leg 412 and the feed connection point 410, a low-band radiating section 418 electrically coupled to the shorting leg 412 and the feed connection point 410, and mounting points 424. However, as seen in FIG. 9B, the shorting leg 412 can taper from a wide end adjacent to the ground plane 414 to a narrow end adjacent to the high-band radiating section 416 and the low-band radiating section 418 to enhance the mechanical stability of the element 400. Furthermore, each of the high-band radiating section 416 and the low-band radiating section 418 can include a respective planar section parallel to the ground plane 414.

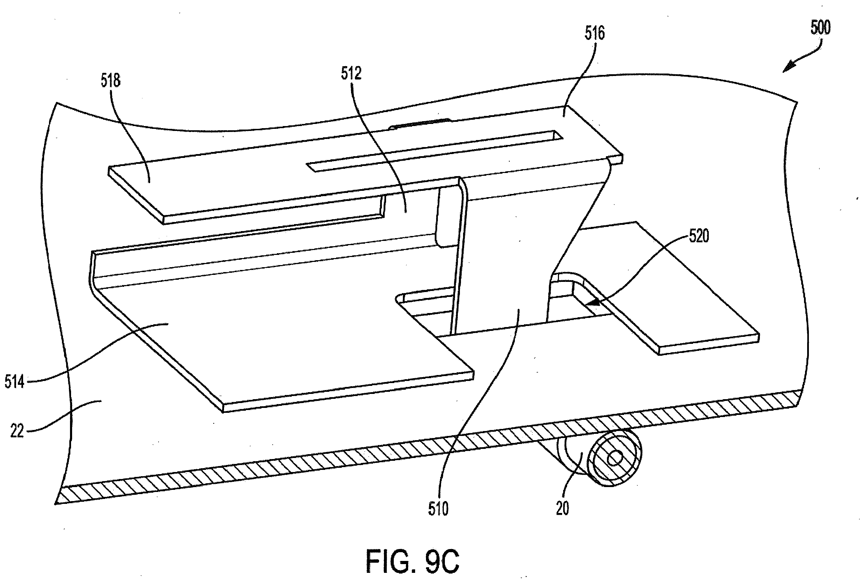

FIG. 9C illustrates yet another element 500 that is fed from the bottom side of a ground and that includes additional sections that increase the mechanical stability of the element 500. The element 500 is similar to the element 200 of FIG. 7 and can exist as a single monolithic structure that forms a feed connection point 510, a shorting leg 512 electrically coupled to the feed connection point 510, a ground plane 514 electrically coupled to the shorting leg 512, a high-band radiating section 516 electrically coupled to the shorting leg 512 and the feed connection point 510, and a low-band radiating section 518 electrically coupled to the shorting leg 512 and the feed connection point 510. However, as seen in FIG. 9C, the element 500 can be coupled to an external structure 22. Furthermore, each of the high-band radiating section 516 and the low-band radiating section 518 can include a respective planar section parallel to the ground plane 514.

In some embodiments, a plurality of elements as disclosed herein can be collocated in a product and form an array. For example, any of the elements 100, 200, 300, 400, 500 of FIG. 1, FIG. 7, FIG. 9A, FIG. 9B, and FIG. 9C, respectively, can be the elements in a multiple-input, multiple-output (MIMO) antenna array that includes two or more of the elements.

Although a few embodiments have been described in detail above, other modifications are possible. For example, other components may be added to or removed from the described systems, and other embodiments may be within the scope of the invention.

From the foregoing, it will be observed that numerous variations and modifications may be effected without departing from the scope of the invention. It is to be understood that no limitation with respect to the specific system or method described herein is intended or should be inferred. It is, of course, intended to cover all such modifications as fall within the scope of the invention.

## Claims

1. An element comprising:
a feed connection point;
a shorting leg electrically coupled to the feed connection point;
a ground plane electrically coupled to the shorting leg;
a high-band radiating section electrically coupled to the shorting leg and the feed connection point; and
a low-band radiating section electrically coupled to the shorting leg and the feed connection point,
wherein the feed connection point, the shorting leg, the ground plane, the high-band radiating section, and the low-band radiating section exist as a single monolithic structure,
wherein the high-band radiating section and the low-band radiating section are elevated off the ground plane and positioned on opposing sides of the shorting leg, and
wherein the feed connection point is isolated from the ground plane to provide a path for current flow from the feed connection point through either the high-band radiating section and the shorting circuit leg or the low-band radiating section and the shorting leg.

2. The element of claim 1 further comprising a coaxial cable having a shield coupled to the ground plane and a center conductor coupled to the feed connection point.

3. The element of claim 2 wherein the shield is coupled to a top side of the ground plane and the feed connection point is isolated from the ground plane by elevating the feed connection point off the ground plane, or wherein the shield is coupled to a bottom side of the ground plane, and wherein the feed connection point is isolated from the ground plane by routing the feed connection point through a cutout portion of the ground plane so a connection to the center conductor occurs below the ground plane.

4. The element of claim 1, 2 or 3 wherein the high-band radiating section includes a first planar section parallel to the ground plane and a second planar section perpendicular to the ground plane.

5. The element of claim 1, 2, 3 or 4 wherein the low-band radiating section includes a bent planar section parallel to the ground plane or a planar section perpendicular to the ground plane.

6. The element of any preceding claim wherein the shorting leg tapers from a wide end adjacent to the ground plane to a narrow end adjacent to the high-band radiating section and the low-band radiating section.

7. The element of any preceding claim wherein the low-band radiating section includes a first length that is one quarter of a wavelength at a low-band design frequency and one half of the wavelength at a high-band design frequency, the high-band radiating section includes a second length that is one quarter of the wavelength at the high-band design frequency, and the shorting leg includes a third length that is between one eighth and one quarter of the wavelength at the high-band design frequency, wherein the first length is measured from a center of the shorting leg to an end of the low-band radiating section, and wherein the second length is measured from the center of the shorting leg to an end of the high-band radiating section.

8. The element of any preceding claim wherein a first height of the high-band radiating section off the ground plane is varied to tune an input impedance of the element in a high frequency band, and wherein a second height of the low-band radiating section off the ground plane is varied to tune to the input impedance of the element in a low frequency band.

9. The element of any preceding claim wherein, when a high frequency signal is fed to the feed connection point, the low-band radiating section has a relatively high impedance that results in the current flow through the high-band radiating section and the shorting leg, and wherein, when a low frequency signal is fed to the feed connection point, the high-band radiating section appears as an electrically short shunt stub, resulting in the current flow through the low-band radiating section and the shorting leg.

10. The element of any preceding claim wherein the ground plane is coupled to an external structure.

11. A method comprising:
stamping and forming a single piece of metal into a single monolithic structure that includes a feed connection point, a shorting leg, a ground plane, a high-band radiating section, and a low-band radiating section;
elevating the high-band radiating section and the low-band radiating section off the ground plane and on opposing sides of the shorting leg;
isolating the feed connection point from the ground plane to create a path for current flow from the feed connection point through either the high-band radiating section and the shorting leg or the low-band radiating section and the shorting leg; and
coupling a shield of a coaxial cable to the ground plane and a center conductor of the coaxial cable to the feed connection point,
wherein the shorting leg is electrically coupled to the feed connection point, the ground plane is electrically coupled to the shorting leg, the high-band radiating section is electrically coupled to the shorting leg and the feed connection point, and the low-band radiating section is electrically coupled to the shorting leg and the feed connection point.

12. The method of claim 11 further comprising:
forming the low-band radiating section to include a first length that is one quarter of a wavelength at a low-band design frequency and one half of the wavelength at a high-band design frequency;
forming the high-band radiating section to include a second length that is one quarter of the wavelength at the high-band design frequency; and
forming the shorting leg to include a third length that is one quarter of the wavelength of at the high-band design frequency,
wherein the first length is measured from a center of the shorting leg to an end of the low-band radiating section, and
wherein the second length is measured from the center of the shorting leg to an end of the high-band radiating section.

13. The method of claim 11 or 12 further comprising the single monolithic structure creating a distributed decoupling circuit that forces low frequency current to the low-band radiating section and high frequency current to the high-band radiating section.

14. The method of claim 11, 12 or 13 further comprising:
coupling the shield of the coaxial cable to a top side of the ground plane and isolating the feed connection point from the ground plane by elevating the feed connection point off the ground plane; or
coupling the shield of the coaxial cable to a bottom side of the ground plane and isolating the feed connection point from the ground plane by routing the feed connection point through a cutout portion of the ground plane so a connection to the center conductor occurs below the ground plane.

15. The method of claim 11, 12, 13 or 14 further comprising coupling the ground plane to an external structure.
